# FASCICULE DE BREVET EUROPEEN

(11) **EP 0 845 787 B1**
(45) Date de publication et mention de la délivrance du brevet: **04.08.1999**
(21) Numéro de dépôt: 97470027.0
(22) Date de dépôt: 05.11.1997
(51) Int. Cl.: G11C 16/06

(54) **Dispositif de protection après une écriture de page d'une mémoire électriquement programmable**
Vorrichtung zum Schützen eines elektrisch programmierbaren Speichers nach dem seitenweisen Beschreiben
Device to protect electrically programmable memory after page writing

(30) Priorité: 28.11.1996 FR 9614776
(43) Date de publication de la demande: 03.06.1998
(73) Titulaire: STMicroelectronics S.A., 94250 Gentilly (FR)
(72) Inventeur: Leconte, Bruno, 57000 Metz (FR); Brigati, Alessandro, 57000 Metz (FR); Devin, Jean, 57000 Metz (FR)
(74) Mandataire: Ballot, Paul Denis Jacques

(56) Documents cités:
- EP-A- 0 272 977
- US-A- 5 363 330
- ZITLAW C A: "RECENT TRENDS IN EMBEDDED CONTROL MEMORY" WESCON TECHNICAL PAPERS, vol. 35, 1 novembre 1991, pages 386-389, XP000320561

## Description

L'invention concerne un dispositif de protection après une écriture de page d'une mémoire électriquement programmable. Ce dispositif sert plus particulièrement aux mémoires de type FLASH, c'est à dire aux mémoires utilisant des transistors à grille flottante programmés par électrons chauds.

Les mémoires de type EEPROM sont des mémoires programmables et effaçables électriquement par effet tunnel (ou effet Fowler Nordheim). Ces mémoires EEPROM sont constituées de cellules mémoires comprenant un transistor à grille flottante et un transistor de sélection qui parfois est commun à un groupe de cellules formant un mot. Ces mémoires sont utilisées de manière courante et des protocoles d'instructions ont été développés par les fabricants de manière à pouvoir être interchangées entre elles.

Les mémoires de types FLASH sont des mémoires programmables électriquement par électrons chauds et effaçable électriquement par effet tunnel. Ces mémoires sont constituées de cellules de mémorisation comportant un unique transistor à grille flottante. Les applications où l'on utilise les mémoires FLASH sont souvent différentes des applications où l'on utilise les mémoires EEPROM. De plus, les mémoires FLASH ne sont classiquement pas compatibles avec les mémoires EEPROM.

Les mémoires FLASH étant moins encombrantes que les mémoires EEPROM et plus rapide à programmer, l'idée de réaliser une mémoire FLASH compatible en fonctionnement avec une mémoire EEPROM classique est née dans l'esprit des fabricants de mémoires. Cependant les modes de programmation étant différents des adaptations sont nécessaires causant certains problèmes à l'homme du métier.

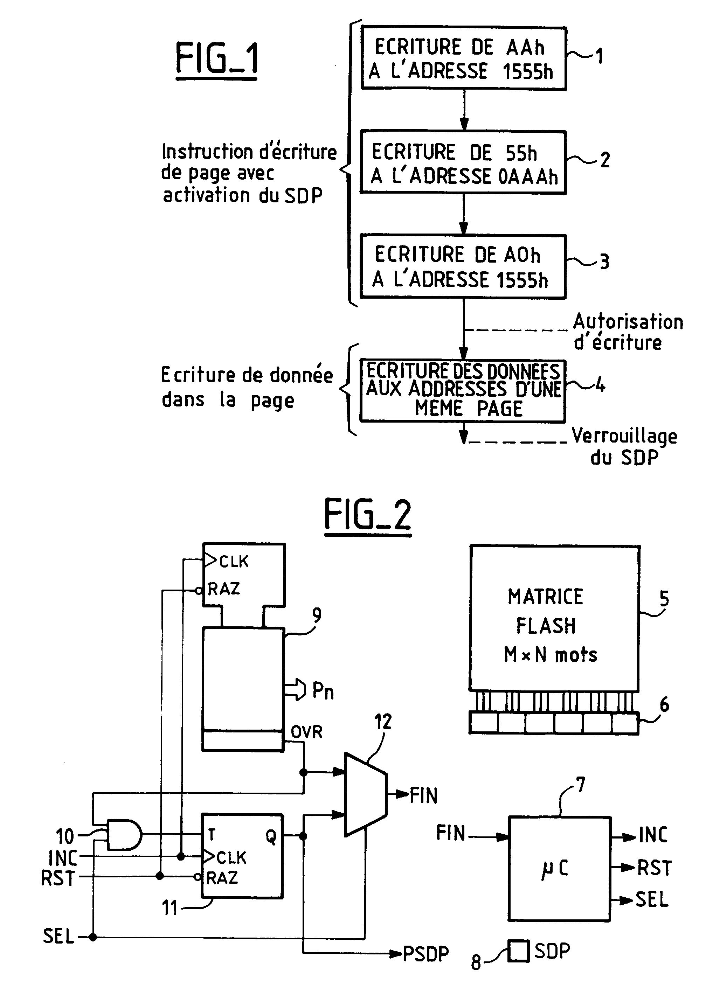

La présente demande de brevet traite essentiellement d'une instruction utilisée de manière courante avec les mémoires de type EEPROM. L'instruction en question est une écriture par page suivie d'une protection en écriture de la mémoire. Si l'on se réfère aux documents constructeurs de fabricant de mémoires EEPROM (communément appelés DATA BOOK), l'instruction est envoyée à la mémoire ainsi: écriture de mots spécifiques à des adresses spécifiques puis écriture des données d'une page donnée, la page étant définie comme contenant toutes les adresses d'une même ligne de mot du plan mémoire. L'écriture de mots spécifiques à des adresses spécifiques constitue l'instruction. A titre d'exemple, la figure 1 reproduit la séquence type qui est donnée par la société connue sous le nom SGS-THOMSON MICROELECTRONICS pour la mémoire commercialisée sous la référence M28C64. Cette séquence est faite pour une mémoire disposant de 13 bits d'adresse et 8 bits de donnée. Les adresses pouvant varier en fonction de la capacité de la mémoire, l'homme du métier peut vérifier que les adresses ont toujours une forme pour les mémoires EEPROM (même alternance de bits).

Dans une mémoire EEPROM, un micro-contrôleur identifie la séquence d'instruction. Puis les données à écrire dans la page sont stockées dans des registres tampon. Lorsque tous les registres correspondant à une page ont reçus une donnée, le micro-contrôleur déclenche une écriture en parallèle dans toutes les cellules de la ligne de mots et dans une cellule de mémorisation, classiquement nommée SDP (de l'anglais Software Data Protection) qui indique que la mémoire est protégée, interdisant l'écriture dans la mémoire. La cellule SDP est du même type que les cellules mémoires constituant le plan mémoire mais est généralement séparée du plan mémoire. Dans les mémoires EEPROM, une simple porte ET, recevant l'ordre d'écriture en mémoire et un bit indiquant l'écriture du SDP, suffit pour effectuer la programmation de la cellule SDP.

La transposition de ce type d'instruction sur une mémoire de type FLASH pose un problème à l'homme du métier. En effet, la programmation par électrons chauds demande une énergie plus importante que la programmation par effet tunnel. De ce fait, l'écriture en parallèle de toutes les données dans la mémoire est impensable dans une mémoire de type FLASH. Pour écrire les données qui sont présentes dans les différents registres, on a recours à une écriture séquentielle programmant la mémoire mot par mot. Cependant il n'est plus possible de gérer la cellule SDP de la même façon qu'une mémoire EEPROM. Une solution évidente consiste à utiliser le micro-contrôleur pour effectuer la programmation de la cellule SDP après avoir terminer l'écriture de la page. Néanmoins, cette solution présente une certaine lourdeur et ralentit le micro-contrôleur.

L'invention a pour but de proposer un dispositif d'écriture de la cellule SDP permettant une écriture automatique de cette cellule SDP sans l'intervention du micro-contrôleur. La solution proposée par l'invention est particulièrement intéressante car elle permet d'utiliser un micro-contrôleur peu différent de celui d'une mémoire EEPROM, réduisant ainsi le temps de mise au point du micro-contrôleur et de son programme.

L'invention a pour objet un circuit de séquencement d'écriture dans une mémoire, de type à grille flottante, programmable par électrons chauds, et ayant une instruction d'écriture par page avec protection en écriture, les données de la page étant stockées temporairement dans des tampons, ledit circuit comportant des premiers moyens pour successivement adresser l'une des colonnes d'une matrice de mémorisation afin d'écrire le contenu de chacun des tampons dans une page de la mémoire et de signaler la fin de l'écriture dans la page, et comportant des deuxièmes moyens pour adresser l'écriture d'un bit de protection uniquement si les premiers moyens signalent la fin de l'écriture dans la page et si un bit indicateur indique que l'on doit activer le bit de protection.

L'invention sera mieux comprise et d'autres avantages apparaîtront à la lecture de la description qui va suivre faisant référence aux dessins annexés parmi lesquels:
la figure 1 représente la séquence de commande à envoyer à une mémoire de type EEPROM qui déclenche l'écriture d'une page suivi d'une protection en écriture,
la figure 2 représente un mode de réalisation préféré de l'invention.

La figure 1 représente comme précédemment énoncé la séquence de commande de l'instruction d'écriture de page et de protection pour une mémoire EEPROM référencé M28C64 par la société connue sous le nom SGS-THOMSON MICROELECTRONICS. Les trois premières étapes 1 à 3 correspondent à une instruction. Des variantes existent en fonction de la capacité de la mémoire.

La première étape 1 consiste à écrire la donnée hexadécimale AA à l'adresse hexadécimale 1555 pour la mémoire précédemment citée, cette mémoire ayant 13 bits d'adresse. Pour une mémoire ayant un nombre de bits d'adresse différent, l'adresse est différente mais correspond à la même alternance de "0" et de "1" sur un nombre de bits différents. La deuxième étape 2 consiste à écrire la donnée héxadécimale 55 à l'adresse héxadécimale 0AAA. La troisième étape 3 consiste à écrire la donnée héxadécimale A0 à l'adresse héxadécimale 1555. Pour les deuxième et troisième étapes 2 et 3, les mêmes modifications d'adresse que pour la première étape 1 sont possibles.

Après réception de ces trois étapes 1 à 3 d'écriture fictive, un micro-contrôleur chargé de la gestion de la mémoire sait qu'il s'agit d'une instruction d'écriture de page suivie d'une protection de la mémoire en écriture. La quatrième étape 4 consiste à envoyer une série de données à différentes adresses d'une page de la mémoire. La désignation page correspond classiquement à toutes les cellules de mémorisation d'une matrice de mémorisation situées sur une même ligne. Le micro-contrôleur va charger les différentes données dans des tampons de mémorisation (généralement des registres volatiles), chaque tampon correspondant à une colonne de la matrice de mémorisation. Lorsque tous les tampons auront reçus une donnée, l'écriture sera effectuée dans la matrice à la page désignée, un bit de protection est écrit simultanément pour indiquer que la mémoire n'est plus accessible en écriture.

Ce principe déjà connu de décodage d'instruction dans une mémoire EEPROM est repris intégralement dans le cadre d'une mémoire EEPROM utilisant une matrice de mémoire FLASH. L'invention ne portant pas sur le principe de décodage de l'instruction, le décodage de l'instruction et l'écriture dans les tampons ne sera pas décrite plus en détail.

La figure 2 représente les éléments nécessaires à la bonne compréhension de l'invention.

Une matrice de mémorisation 5 de type FLASH, c'est à dire n'ayant qu'un unique transistor à grille flottante dans chaque cellule de mémorisation, organisée en M lignes de N mots constitue le plan de mémorisation de la mémoire. A titre d'exemple, pour une mémoire d'une capacité de 64 kilobits, on peut utiliser des mots de huit bits et avoir M = 128, N = 64. Chacune des lignes est connectée à un décodeur de ligne (non représenté) et chacune des colonnes est connectée d'une part à un dispositif de lecture (non représenté) et d'autre part à des tampons volatiles 6. Les tampons volatiles 6 sont classiquement des registres qui servent à mémoriser les données à écrire dans la mémoire afin de réduire le temps d'accès en écriture. Les tampons volatiles 6 ont une capacité de mémorisation égale à la capacité de mémorisation d'une ligne complète de la matrice de mémorisation 5, permettant ainsi de mémoriser une page complète.

Un micro-contrôleur 7 est chargé de la supervision de la mémoire. Ce micro-contrôleur 7 a pour charge d'envoyer et de recevoir différents signaux de contrôle et de commande aux différents organes de la mémoire afin d'assurer le fonctionnement de la mémoire. Le micro-contrôleur 7 comprend les moyens connus dans les mémoires EEPROM pour assurer le décodage d'instruction et l'écriture dans les tampons volatiles 6. Seuls les signaux utiles à la bonne compréhension de l'invention ont été représentés. Le micro-contrôleur 7 comporte une entrée recevant un signal de fin d'écriture FIN, une première sortie fournissant un signal SEL indiquant la protection à faire à l'issue de l'écriture d'une page en mémoire, une deuxième sortie fournissant un signal RST de début d'une séquence d'écriture de page, et une troisième sortie fournissant un signal INC de séquencement d'écriture en mémoire. Les signaux de l'entrée et des première et deuxième sorties sont identiques aux signaux d'une mémoire EEPROM classique. Le signal de séquencement d'écriture est propre aux signaux d'écriture utilisés dans une mémoire FLASH classique; à titre d'exemple, lorsqu'il est à "1", le signal INC valide une écriture d'un mot dans la mémoire, et lorsqu'il est à "0", le signal INC indique la fin d'un phase d'écriture. Ce signal d'écriture va en fait commander différents organes nécessaires à la programmation qui servent à générer et convoyer les différentes tensions nécessaires à la programmation bien connu par l'homme du métier qui utilise les mémoires de type FLASH.

Une cellule de protection 8 contient le bit de protection en écriture SDP. Cette cellule est identique à une cellule de mémorisation de la matrice 5 mais peut être située n'importe où dans la mémoire. Les connexions de cette cellule servant à la programmer ou à la lire n'ont pas été représentées mais sont identiques aux moyens nécessaires pour lire et écrire une cellule mémoire de type FLASH et peuvent être communs à d'autres cellules mémoires contenant d'autres indicateurs.

Un compteur 9 possède une entrée d'horloge, une entrée de remise à zéro, un bus de sortie et une sortie de retenue. Dans le cas d'une écriture de page, ce compteur 9 est remis à zéro par le signal RST puis est incrémenté après chaque écriture en mémoire, le signal INC étant reçu sur l'entrée d'horloge, et le bus de sortie Pn indiquant à un décodeur de colonne quelle colonne de mot doit être écrite. Lorsque le compteur a effectué un tour de compteur il active un signal OVR sur la sortie de retenue.

Une porte ET 10, ayant deux entrées et une sortie reçoit sur l'une de ses entrées le signal OVR et sur l'autre de ses entrées le signal SEL. La sortie de la porte ET est active lorsque le signal OVR et le signal SEL sont actifs simultanément.

Une bascule 11, de type T, possède une entrée de signal, une entrée d'horloge, une entrée de remise à zéro, et une sortie. L'entrée de signal est connectée à la sortie de la porte ET 10. L'entrée d'horloge reçoit le signal INC. L'entrée de remise à zéro reçoit le signal RST. La sortie fournit un signal PSDP de programmation du bit SDP qui déclenche l'écriture de la cellule de protection 8 lorsque ledit signal PSDP est actif. La bascule 11 est initialisée à zéro lorsque l'on commence une séquence d'écriture de page et ne bascule dans un état actif qu'après l'écriture du dernier mot d'une page lorsque le signal SEL est actif.

Un multiplexeur 12 possède deux entrées de signal, une entrée de sélection, et une sortie. L'une des entrées de signal reçoit le signal OVR et l'autre des entrées de signal reçoit le signal PSDP. La sortie fournit le signal FIN. L'entrée de sélection reçoit le signal SEL de sorte que lorsque l'on effectue une écriture de page sans protection le signal FIN correspond au signal OVR et lorsque l'on effectue une écriture de page avec protection le signal FIN correspond au signal PSDP.

Ainsi lorsque le micro-contrôleur effectue une écriture de page sans protection, il fournit un signal RST actif au début de la séquence d'écriture et fournit un signal SEL inactif. Le compteur 9 va compter toutes les adresses d'une page cadencé par le signal d'écriture INC. Puis à l'issue du comptage le signal FIN va devenir actif indiquant au micro-contrôleur 7 la fin de l'écriture de la page.

Par contre, lorsque le micro-contrôleur effectue une écriture de page avec protection, il fournit un signal RST actif au début de la séquence d'écriture et fournit un signal SEL actif. Le compteur 9 va compter toutes les adresses d'une page cadencé par le signal d'écriture INC. Puis à l'issue du comptage la bascule 11 va activer le signal PSDP commandant l'écriture du bit de protection SDP. Le signal FIN devient actif lors de l'écriture du bit de protection SDP, indiquant au micro-contrôleur 7 la fin de l'écriture de la page après l'écriture du bit de protection.

Un tel dispositif permet d'utiliser un micro-contrôleur 7 programmé indépendamment du nombre de colonnes de la matrice 5. Néanmoins, le compteur 9 doit tenir compte du nombre de colonnes.

De nombreuses variantes sont envisageables. Dans l'exemple de réalisation préféré, on a utilisé un compteur et une bascule T.

En fait, le compteur 9 peut être remplacé par n'importe quels types de moyens permettant d'adresser successivement l'une des colonnes d'une matrice de mémorisation afin d'écrire le contenu de chacun des tampons volatiles 6 dans une page de la mémoire et indiquer la fin de l'écriture de la page. On peut, par exemple, utiliser un registre à décalage mais la surface occupée par un registre à décalage serait beaucoup plus importante.

La bascule T 11 et la porte ET 10 peuvent être remplacées par des moyens permettant l'adressage de l'écriture de la cellule 8 contenant le bit de protection SDP lorsque le compteur 9 (ou les moyens équivalents) indique la fin de l'écriture dans la page et si le bit SEL est actif, indiquant que l'on doit activer le bit SDP. Tout type de bascule peut être utilisé, une bascule de type RS convient tout à fait à partir du moment où elle peut fournir sur une sortie un signal de programmation du bit de protection SDP. Cependant suivant le type de bascule utilisé et suivant l'état actif des signaux, la porte ET 10 doit être remplacée par une porte équivalente.

Le multiplexeur 12 est un multiplexeur au sens large. C'est à dire qu'il s'agit d'un dispositif d'aiguillage d'information ayant un fonctionnement de multiplexeur. Des sorties de type trois états ont une fonctionnalité équivalente et permettent de supprimer ce multiplexeur 12.

## Revendications

1. Circuit de séquencement d'écriture dans une mémoire, de type à grille flottante, programmable par électrons chauds, et ayant une instruction d'écriture par page avec protection en écriture, les données de la page étant stockées temporairement dans des tampons (6) caractérisé en ce qu'il comporte:
- des premiers moyens (9) pour successivement adresser l'une des colonnes d'une matrice de mémorisation (5) afin d'écrire le contenu de chacun des tampons (6) dans une page de la mémoire et de signaler la fin de l'écriture (OVR) dans la page,
- des deuxièmes moyens (10, 11) pour adresser l'écriture d'un bit de protection (SDP) uniquement si les premiers moyens (9) signalent la fin de l'écriture (OVR) dans la page et si un bit indicateur (SEL) indique que l'on doit activer le bit de protection (SDP).

2. Circuit selon la revendication 1, caractérisé en ce qu'il comporte un multiplexeur (12) pour fournir à un micro-contrôleur (7) une information de fin de programmation (FIN) provenant soit des premiers moyens (9) soit des deuxièmes moyens (10, 11) suivant l'état du bit indicateur (SEL).

3. Circuit selon l'une des revendication 1 ou 2, caractérisé en ce que les premiers moyens (9) comprennent un compteur (9) ayant une première entrée pour recevoir un signal d'horloge correspondant à un signal d'écriture (INC), une deuxième entrée pour recevoir un signal de remise à zéro (RST), une sortie parallèle pour fournir un nombre (Pn) correspondant à l'adresse de l'une des colonnes d'une matrice (5) de la mémoire, et une sortie de fin de comptage (OVR) pour signaler que le comptage est terminé et que la programmation de la page est terminée.

4. Circuit selon l'une des revendications 1 à 3, caractérisé en ce que les deuxièmes moyens (10, 11) comporte une bascule de mémorisation (11) qui fournit sur une sortie un signal de programmation (PSDP) du bit de protection.

## Patentansprüche

1. Schaltkreis zur Sequenzierung des Beschreibens eines Speichers mit schwimmendem, mit heißen Elektronen programmierbarem Gate und einer Instruktion zum seitenweisen Schreiben mit Schreibschutz, wobei die Daten der Seite temporär in Zwischenspeichern (6) abgelegt werden, gekennzeichnet durch:
- erste Mittel (9) zum sukzessiven Adressieren einer der Spalten einer Speichermatrix (5) zum Schreiben des Inhalts von jedem der Zwischenspeicher (6) in eine Seite des Speichers und zum Anzeigen des Endes des Beschreibens der Seite (OVR) sowie
- zweite Mittel (10, 11), um das Beschreiben eines Schutzbits (SDP) nur dann zu adressieren, wenn die ersten Mittel (9) das Ende des Beschreibens (OVR) der Seite anzeigen und ein Indikatorbit (SEL) anzeigt, daß das Schutzbit (SDP) zu aktivieren ist.

2. Schaltkreis nach Anspruch 1, dadurch gekennzeichnet, daß er einen Multiplexer (12) aufweist, um an einen Mikrocontroller (7) eine Information des Endes der Programmierung (FIN) zu liefern, die entweder von den ersten Mitteln (9) oder von den zweiten Mitteln (10, 11) kommt, je nach dem Status des Indikatorbits (SEL).

3. Schaltkreis nach einem der Ansprüche 1 oder 2, dadurch gekennzeichnet, daß die ersten Mittel (9) einen Zähler (9) umfassen mit
- einem ersten Eingang zur Aufnahme eines Taktimpulses, der einem Schreibsignal (INC) entspricht,
- einem zweiten Eingang zur Aufnahme eines Reset-Signals (RST),
- einem parallelen Ausgang zur Lieferung einer entsprechenden Zahl (Pn) an die Adresse einer der Spalten einer Matrix (5) des Speichers sowie
- einem Zählungsendeausgang (OVR) zur Anzeige des Endes der Zählung und des Endes der Seitenprogrammierung.

4. Schaltkreis nach einem der Ansprüche 1 bis 3, dadurch gekennzeichnet, daß die zweiten Mittel (10, 11) ein Speicher-Flip-Flop (11) umfassen, das an einen Ausgang ein Programmiersignal (PDSP) des Schutzbits ausgibt.

## Claims

1. Circuit for sequencing writing in a memory, of the floating gate type, programmable by hot electrons, and having an instruction for writing by page after write protection, the data for the page being stored temporarily in buffers (6), characterised in that it has:
- first means (9) for successively addressing one of the columns of a storage matrix (5) in order to write the content of each of the buffers (6) in a page of the memory and indicate the end of the writing (OVR) in the page,
- second means (10, 11) for addressing the writing of a protection bit (SDP) solely if the first means (9) indicate the end of the writing (OVR) in the page and if an indicator bit (SEL) indicates that the protection bit (SDP) is to be activated.

2. Circuit according to Claim 1, characterised in that it includes a multiplexer (12) for supplying to a microcontroller (7) end of programming information (FIN) coming either from the first means (9) or from the second means (10, 11) depending on the state of the indicator bit (SEL).

3. Circuit according to one of Claims 1 or 2, characterised in that the first means (9) comprise a counter (9) having a first input for receiving a clock signal corresponding to a write signal (INC), a second input for receiving a reset signal (RST), a parallel output for supplying a number (Pn) corresponding to the address of one of the columns of a matrix (5) of the memory, and an end of counting output (OVR) for indicating that the counting is terminated and that the programming of the page is terminated.

4. Circuit according to one of Claims 1 to 3, characterised in that the second means (10, 11) include a storage flip-flop (11) which supplies, at an output, a signal (PSDP) for programming of the protection bit.
